# EUROPEAN PATENT SPECIFICATION

(11) **EP 4 124 196 B1**
(45) Date of publication and mention of the grant of the patent: **11.12.2024**
(21) Application number: 20925084.4
(22) Date of filing: 18.03.2020
(51) Int. Cl.: H05K 13/08

(54) **DATA MANAGEMENT DEVICE AND DATA MANAGEMENT METHOD**
DATENVERWALTUNGSVORRICHTUNG UND DATENVERWALTUNGSVERFAHREN
DISPOSITIF DE GESTION DE DONNÉES ET PROCÉDÉ DE GESTION DE DONNÉES

(43) Date of publication of application: 25.01.2023
(73) Proprietor: Fuji Corporation, Chiryu-shi, Aichi 472-8686 (JP)
(72) Inventor: OHASHI, Teruyuki, Chiryu-shi, Aichi 472-8686 (JP)
(74) Representative: Grünecker Patent- und Rechtsanwälte PartG mbB
(86) International application number: PCT/JP2020/012025
(87) International publication number: WO 2021/186623

(56) References cited:
- EP-A1- 3 624 576
- WO-A1-2014/102911
- WO-A1-2015/079560
- WO-A1-2018/207280
- JP-A- 2007 035 892
- JP-A- 2016 115 915

## Description

### Technical Field

The present specification discloses techniques related to a data management device and a data management method.

### Background Art

A data management device described in Patent Literature 1 stores a reference work file including work data used in a surface mounting facility. In addition, the data management device includes a reception section and a data correction section. The reception section receives a correction file for the reference work file from the surface mounting facility. The data correction section corrects the relevant work data among the at least one work data constituting the reference work file so as to correspond to the received correction file, and corrects the reference work file so that a sender that has transmitted the correction file is displayed. In addition, the data correction section corrects the work data corresponding to the correction file in different hues or forms by a device that has transmitted the correction file or by the sender of the correction file. Another example is known from WO 2018/207280 A1.

### Patent Literature

Patent Literature 1: JP-A-2016-115915

### Summary of the Invention

### Technical Problem

Data used in a mounting process for mounting a component on a substrate is copied for each predetermined data group and used in multiple component mounters. In the data group used in the component mounter, for example, there is a possibility that the data included in the data group is changed for the purpose of improving the mounting process. As a result, even in a data group of the same type, there would be a case where the data included in the data group are different from each other. In a case where an operator confirms whether there is a change in the data, it is difficult to find a data group including the changed data as the number of types of data groups increases, and thus, a confirmation operation of the changed data is complicated.

In view of such a circumstance, the present specification discloses a data management device and a data management method capable of identifying a data group with which a data group in which at least one data included in a data group that is a set of data used in a mounting process is changed is associated.

### Solution to Problem

The invention is defined by the features of the independent claims. Further embodiments are defined in the dependent claims.

### Advantageous Effect of the Invention

According to the above-described data management device, a determination section and an output section are provided. As a result, the data management device can identify a specific reference data group with which a derivative data group in which at least one data included in a data group is changed is associated. The above description of the data management device can be similarly applied to a data management method.

### Brief Description of Drawings

[Fig. 1] Fig. 1 is a configuration diagram illustrating a configuration example of a substrate working line.
[Fig. 2] Fig. 2 is a plan view illustrating a configuration example of a component mounter.
[Fig. 3] Fig. 3 is a block diagram illustrating an example of a control block of a data management device.
[Fig. 4] Fig. 4 is a flowchart illustrating an example of a control procedure by the data management device.
[Fig. 5] Fig. 5 is a schematic diagram illustrating an example of a relationship among data, a data group, a reference data group, an association data group, a derivative data group, a specific reference data group, and a normal reference data group.
[Fig. 6] Fig. 6 is a schematic diagram illustrating a display example of a substrate image when a data group is mounting-related data.
[Fig. 7] Fig. 7 is a schematic diagram illustrating a display example of a component accommodation image when the data group is the mounting-related data.
[Fig. 8] Fig. 8 is a schematic diagram illustrating a display example of a list display when the data group is the mounting-related data.
[Fig. 9] Fig. 9 is a schematic diagram illustrating a display example of a substrate image when the data group is component-related data.
[Fig. 10] Fig. 10 is a schematic diagram illustrating a display example of a component accommodation image when the data group is the component-related data.
[Fig. 11] Fig. 11 is a schematic diagram illustrating a display example of a list display when the data group is the component-related data.
[Fig. 12] Fig. 12 is a schematic diagram illustrating a display example of correspondence data between a specific reference data group and a derivative data group.

### Description of Embodiments

### 1. Embodiment

### 1-1. Configuration example of substrate working line WL0

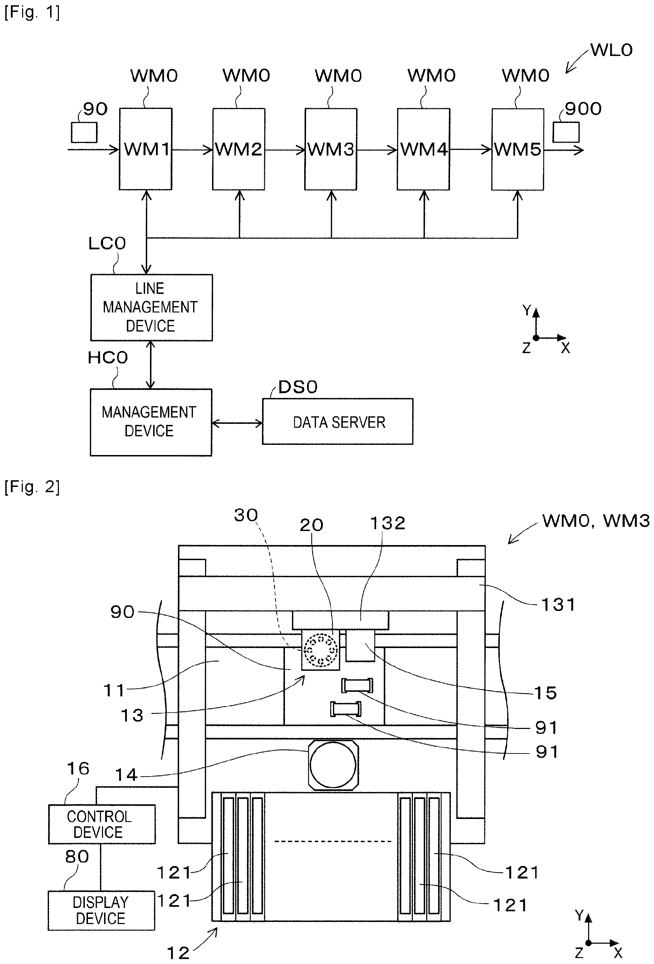

In substrate working line WL0, a predetermined substrate work is performed on substrate 90. The type and number of substrate working machines WM0 constituting substrate working line WL0 are not limited. As illustrated in Fig. 1, substrate working line WL0 of the present embodiment includes multiple (five) substrate working machines WM0 of printer WM1, printing inspector WM2, component mounter WM3, reflow furnace WM4, and appearance inspector WM5, and substrate 90 is conveyed in this order by a substrate conveyance device.

Printer WM1 prints solder on mounting positions of multiple components 91 of substrate 90. Printing inspector WM2 inspects a printing state of the solder which is printed by printer WM1. As illustrated in Fig. 2, component mounter WM3 mounts multiple components 91 on substrate 90 on which solder is printed by printer WM1. One or multiple component mounters WM3 may be provided. In a case in which multiple component mounters WM3 are provided, multiple component mounters WM3 can be shared to mount multiple components 91.

Reflow furnace WM4 heats substrate 90 on which multiple components 91 are mounted by component mounter WM3, causes the solder to melt, and performs soldering. Appearance inspector WM5 inspects a mounting state of multiple components 91 which are mounted by component mounter WM3. In this manner, substrate working line WL0 can convey substrate 90 in order using multiple (five) substrate working machines WM0, execute production processing including inspection processing, and produce substrate product 900. It should be noted that substrate working line WL0 may include substrate working machine WM0 such as a function tester, a buffer device, a substrate supplying device, a substrate flipping device, a shield mounting device, an adhesive application device, and an ultraviolet ray irradiation device as required, for example.

Multiple (five) substrate working machines WM0 and line management device LCO constituting substrate working line WL0 are communicably connected by a communication section. Line management device LCO and management device HCO are communicably connected by a communication section. The communication section can communicably connect them by wired or wireless communication, and a communication method can take various methods.

In the present embodiment, a local area network (LAN) is configured by multiple (five) substrate working machines WM0, line management device LCO, and management device HCO. Therefore, multiple (five) substrate working machines WM0 can communicate with each other via the communication section. In addition, multiple (five) substrate working machines WM0 can communicate with line management device LCO via the communication section. In addition, line management device LCO and management device HCO can communicate with each other via a communication section.

Line management device LCO controls multiple (five) substrate working machines WM0 constituting substrate working line WL0, and monitors an operation situation of substrate working line WL0. Line management device LCO stores various control data for controlling multiple (five) substrate working machines WM0. Line management device LCO transmits the control data to each of multiple (five) substrate working machines WM0. In addition, each of multiple (five) substrate working machines WM0 transmits the operation situation and the production situation line management device LC0.

Management device HCO manages at least one line management device LC0. For example, the operation situation and the production situation of substrate working machine WM0 acquired by line management device LCO are transmitted to management device HCO as required. Management device HCO is provided with data server DS0. Data server DS0 can store various types of acquired data acquired by substrate working machine WM0. For example, various image data imaged by substrate working machine WM0 are included in the acquired data. The record (log data) of the operation status acquired by substrate working machine WM0 is included in the acquired data.

In addition, data server DS0 can store various production information related to the production of substrate product 900. For example, mounting-related information and component-related information described later are included in the production information. In addition, inspection reference information used when the inspection machine such as printing inspector WM2 and appearance inspector WM5 inspects an object is included in the production information. Furthermore, an inspection result obtained by an inspection machine is included in the production information. Further, quality information (traceability information) of substrate products 900 is included in the production information.

1-2. Configuration example of component mounter WM3

Component mounter WM3 mounts multiple components 91 on substrate 90. As illustrated in Fig. 2, component mounter WM3 includes substrate conveyance device 11, component supply device 12, component transfer device 13, part camera 14, substrate camera 15, and control device 16.

For example, substrate conveyance device 11 includes a belt conveyor, and conveys substrate 90 in a conveyance direction (X-axis direction). Substrate 90 is a circuit board, on which an electronic circuit, an electrical circuit, a magnetic circuit, and the like are formed. Substrate conveyance device 11 carries substrate 90 in component mounter WM3, and positions substrate 90 at a predetermined position inside the machine. After a mounting process of multiple components 91 by component mounter WM3 is terminated, substrate conveyance device 11 carries substrate 90 out of component mounter WM3.

Component supply device 12 supplies multiple components 91 to be mounted on substrate 90. Component supply device 12 includes multiple feeders 121 that are provided along the conveyance direction of substrate 90 (X-axis direction). Each of multiple feeders 121 performs pitch-feeding of a carrier tape, in which multiple components 91 are accommodated, and supplies components 91 to be picked up at a supply position located on a distal end side of feeder 121. Also, component supply device 12 can supply the relatively large electronic component (lead component) as compared with the chip component or the like in a state of being disposed on a tray.

Component transfer device 13 includes head driving device 131 and moving body 132. Head driving device 131 is configured to move moving body 132 in the X-axis direction and the Y-axis direction by a linear motion mechanism. Mounting head 20 is detachably (exchangeably) provided on moving body 132 by a clamp member. Mounting head 20 picks up and holds component 91 supplied by component supply device 12 by using at least one holding member 30, and mounts component 91 on substrate 90 positioned by substrate conveyance device 11. As holding member 30, for example, a suction nozzle, a chuck, or the like can be used.

A well-known imaging device can be used as part camera 14 and substrate camera 15. Part camera 14 is fixed to a base of component mounter WM3 such that an optical axis faces upward in a vertical direction (Z-axis direction). Part camera 14 can capture an image of component 91 held by holding member 30 from the lower side. Substrate camera 15 is provided on moving body 132 of component transfer device 13 such that the optical axis faces downward in the vertical direction (Z-axis direction). Substrate camera 15 can image substrate 90 from above. Part camera 14 and substrate camera 15 perform imaging based on a control signal transmitted from control device 16. Image data of a captured image imaged by part camera 14 and substrate camera 15 is transmitted to control device 16.

Control device 16 includes a known arithmetic device and a storage device, and constitutes a control circuit. The information, image data, and the like output from various sensors provided in component mounter WM3 are input to control device 16. Control device 16 transmits control signals to each device based on a control program, a predetermined mounting condition set in advance, and the like.

For example, control device 16 causes substrate camera 15 to image substrate 90 positioned by substrate conveyance device 11. Control device 16 performs image processing of the captured image imaged by substrate camera 15 to recognize a positioning state of substrate 90. Moreover, control device 16 causes holding member 30 to pick up and hold component 91 supplied by component supply device 12, and causes part camera 14 to image component 91 held by holding member 30. Control device 16 performs image processing on the captured image imaged by part camera 14 to recognize a holding posture of component 91.

Control device 16 moves holding member 30 upwards a mounting planned position set in advance by a control program or the like. Further, based on the positioning state of substrate 90, the holding posture of component 91, and the like, control device 16 corrects the mounting planned position to set the mounting position on which component 91 is actually mounted. The mounting planned position and the mounting position include a rotation angle in addition to the position (an X-axis coordinate and a Y-axis coordinate).

Control device 16 corrects a target position (the X-axis coordinate and the Y-axis coordinate) of holding member 30 and the rotation angle according to the mounting position. Control device 16 lowers holding member 30 at the corrected rotation angle at the corrected target position to mount component 91 on substrate 90. Control device 16 repeats a pick-and-place cycle to execute the mounting process of mounting multiple components 91 on substrate 90.

### 1-3. Configuration example of data management device 70

Data 50 used in the mounting process of mounting component 91 on substrate 90 is copied for each predetermined data group 60 and used in multiple component mounters WM3. As for data group 60 used in component mounter WM3, for example, there is a possibility that data 50 included in data group 60 is changed for the purpose of improving the mounting process. As a result, even in the same type of data group 60, data 50 included in data group 60 may differ from each other. In a case where an operator confirms whether data 50 is changed, as the number of types of data group 60 increases, it is difficult to find data group 60 including changed data 50 and the confirmation operation of changed data 50 is complicated. Therefore, data management device 70 is provided in substrate working line WL0 of the present embodiment.

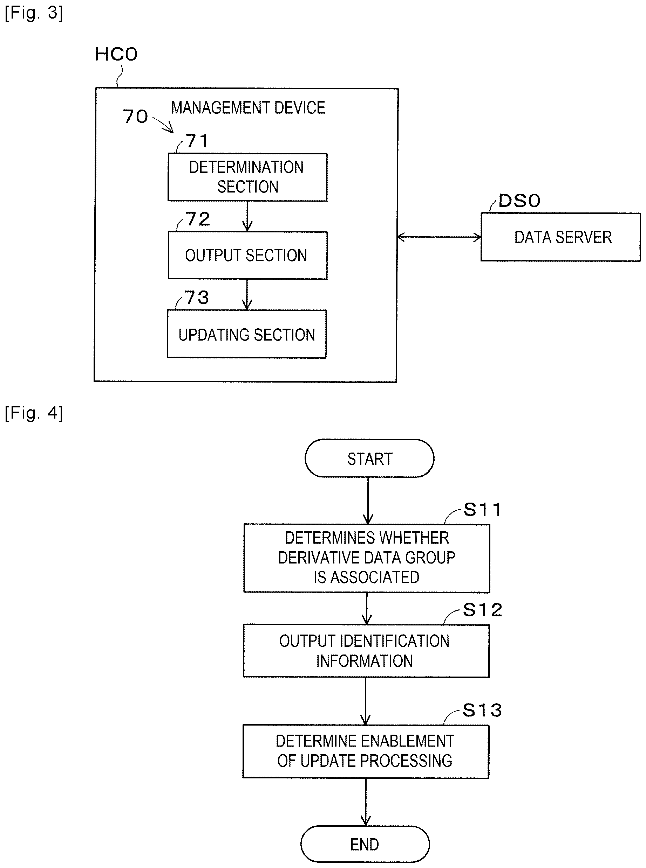

Data management device 70 can be provided in various arithmetic devices. For example, data management device 70 can be provided in an arithmetic device (programming device) for creating a control program, line management device LC0, management device HC0, control device 16 of component mounter WM3, or the like. Data management device 70 may be formed on a cloud. As illustrated in Fig. 3, data management device 70 of the present embodiment is provided in management device HC0.

Moreover, data group 60 may be stored in a storage device of one device, or may be distributed and stored in storage devices of multiple devices. For example, as illustrated in Fig. 3, data group 60 can be stored in a storage device (for example, data server DS0) of management device HC0. In addition, for the same type of data group 60, at least one data group 60 may be stored in the storage device (for example, data server DS0) of management device HC0, and other data groups 60 may be stored in each of a programming device, line management device LC0, control device 16 of component mounter WM3, and the like.

### 1-3-1. Determination section 71 and output section 72

When viewed as a control block, data management device 70 includes determination section 71 and output section 72. Data management device 70 may also include updating section 73. As illustrated in Fig. 3, data management device 70 of the present embodiment includes determination section 71, output section 72, and updating section 73. In addition, data management device 70 executes control according to a flowchart illustrated in Fig. 4. Determination section 71 performs the processing illustrated in Step S11. Output section 72 performs the processing illustrated in Step S12. Updating section 73 performs the processing illustrated in Step S13.

Here, a set of data 50 used in the mounting process for mounting component 91 on substrate 90 is defined as data group 60. One of multiple data groups 60 is defined as reference data group 61, and data group 60 managed in association with reference data group 61 is defined as association data group 62. One of association data groups 62 that includes difference data 51, which is correspondence data corresponding to data 50 of reference data group 61 that differs from data 50 of reference data group 61, is defined as derivative data group 63.

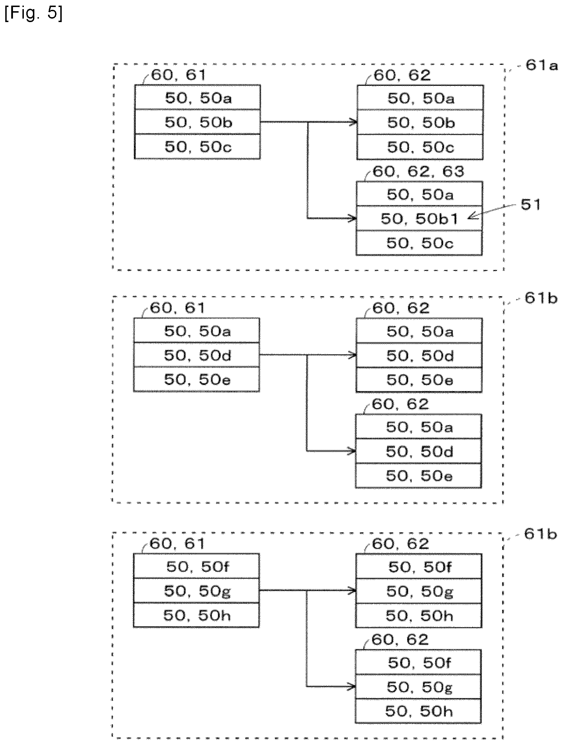

Fig. 5 illustrates an example of a relationship among data 50, data group 60, reference data group 61, association data group 62, derivative data group 63, specific reference data group 61a, and normal reference data group 61b. One type of reference data group 61 illustrated in the upper portion of the drawing includes three pieces of data 50, that is, data 50a, data 50b, and data 50c. One of association data groups 62 managed in association with reference data group 61 includes three pieces of data 50, that is, data 50a, data 50b, and data 50c. Another one of association data groups 62 managed in association with reference data group 61 includes three pieces of data 50, that is, data 50a, data 50b1, and data 50c.

In one of association data groups 62, all the correspondence data included in it coincide with data 50 of reference data group 61 and is not derivative data group 63. Meanwhile, in another one of association data groups 62, data 50b1 which is the correspondence data corresponding to data 50b of reference data group 61 differs from data 50b of reference data group 61. That is, data 50b1 is difference data 51. Moreover, association data group 62 is derivative data group 63. In the present specification, reference data group 61 to which derivative data group 63 is associated in this manner is defined as specific reference data group 61a.

One type of reference data group 61 illustrated in the middle portion of the drawing includes three pieces of data 50, that is, data 50a, data 50d, and data 50e. Each of the two association data groups 62 managed in association with reference data group 61 includes three pieces of data 50, that is, data 50a, data 50d, and data 50e. In each of two association data groups 62, all the correspondence data included in it coincide with data 50 of reference data group 61, and is not derivative data group 63. In the present specification, reference data group 61 to which derivative data group 63 is not associated in this manner is defined as normal reference data group 61b.

The above description of one type of reference data group 61 illustrated in the middle portion of the drawing can be similarly applied to one type of reference data group 61 illustrated in the lower portion of the drawing. Data group 60 includes three pieces of data 50, that is, data 50f, data 50g, and data 50h. The association of data group 60 is performed, for example, by the name of data group 60, identification information for identifying data group 60, or the like. In addition, in multiple types of reference data groups 61, the number of association data groups 62 and the number of derivative data groups 63 managed in association with reference data group 61 may be different from each other. In addition, the number of pieces of data 50 included in data group 60 may be different from each other in multiple types of reference data groups 61.

Determination section 71 determines whether derivative data group 63 is associated with each of multiple types of reference data groups 61 (Step S11 illustrated in Fig. 4). In the example illustrated in Fig. 5, determination section 71 determines that derivative data group 63 is associated with one type of reference data group 61 illustrated in the upper portion of Fig. 5. In addition, determination section 71 determines that derivative data group 63 is not associated with one type of reference data group 61 illustrated in the middle portion of the drawing. In addition, determination section 71 determines that derivative data group 63 is not associated with one type of reference data group 61 illustrated in the lower portion of Fig. 4.

Output section 72 outputs the identification information for identifying specific reference data group 61a so as to be distinguishable from the identification information for identifying normal reference data group 61b, based on the determination result by determination section 71 (Step S12 illustrated in Fig. 4). Output section 72 may take any form as long as it can output the identification information for identifying specific reference data group 61a so as to be distinguishable from the identification information for identifying normal reference data group 61b.

For example, output section 72 can display a substrate image, a component accommodation image, a list display, and the like on display device 80. The substrate image schematically illustrates a state in which multiple components 91 are mounted on substrate 90. The component accommodation image schematically illustrates a state in which multiple component accommodation sections are installed in component supply device 12. The list display lists identification information of multiple types of reference data groups 61.

As display device 80, a well-known display device can be used as long as the above-mentioned information can be displayed. Display device 80 may be provided in a programming device, management device HC0, line management device LC0, component mounter WM3, or the like. Display device 80 of the present embodiment is configured by a touch panel and also serves as an input device for receiving various operations by the operator.

### 1-3-2. Output example when data group 60 is mounting-related data

For example, it is assumed that data group 60 is mounting-related data. The mounting-related data includes data 50 in which mounting-related information that is information about at least one of an pickup position of component 91 to be used in the mounting process, a mounting position of component 91, a mounting order of component 91, a device to be used in the mounting process, and a use condition of the device is stored. The information about the pickup position of component 91 includes information about the position at which the component accommodation section (for example, feeder 121, the tray, or the like) is installed in component supply device 12.

The information about the mounting position of component 91 includes information about the coordinates (X-coordinate and Y-coordinate) and a rotation angle of component 91 to be mounted on substrate 90. The information about the mounting order of the components 91 includes information about the mounting order of multiple components 91 to be mounted on substrate 90. The devices used for the mounting process include substrate working line WL0, component mounter WM3, mounting head 20, holding member 30, part camera 14, substrate camera 15, and the like. The information about the device used in the mounting process includes information about identification information or the like for identifying the device. For example, the information about the use condition of the device includes information about the movement speeds and types of mounting head 20 and holding member 30, the imaging conditions of part camera 14 and substrate camera 15, and the like.

Output section 72 can allow display device 80 to display a substrate image of specific reference data group 61a schematically indicating the state in which multiple components 91 are mounted on substrate 90 so as to be distinguishable from a substrate image of normal reference data group 61b schematically indicating the state in which multiple components 91 are mounted on substrate 90.

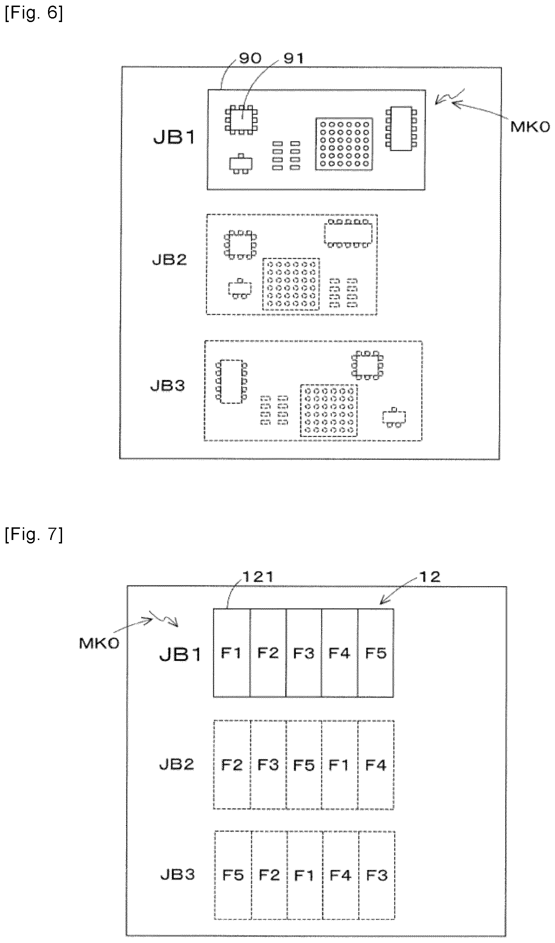

Fig. 6 illustrates a display example of a substrate image when data group 60 is mounting-related data. In the drawing, the identification information for identifying specific reference data group 61a illustrated in Fig. 5 is illustrated by a substrate image of substrate product 900 produced using the mounting-related data of the specific reference data group 61a. In addition, the identification information for identifying normal reference data group 61b illustrated in Fig. 5 is illustrated by the substrate image of substrate product 900 produced using the mounting-related data of normal reference data group 61b.

In Fig. 6, the substrate image of specific reference data group 61a is indicated by solid lines, and the substrate image of normal reference data group 61b is indicated by dashed lines. As long as output section 72 can allow display device 80 to display multiple types of substrate images in a distinguishable manner, the display method is not limited. For example, output section 72 can change the display method of display device 80 according to at least one of a difference in display color, presence or absence of a marker, and a difference in an icon.

For example, output section 72 can display the substrate image of specific reference data group 61a by a display color (for example, yellow, red, or the like) that is easier for the operator to pay attention to than the display color of the substrate image of normal reference data group 61b. Moreover, the same applies to the marker and the icon, and may take various forms such as a display color, a form, a movement in a display screen, and a blinking display that can be easily noticed by the operator. In Fig. 6, arrow MK0 is displayed for the substrate image of specific reference data group 61a. The substrate image displayed on display device 80 corresponds to an icon.

In Fig. 6, character information JB1 for identifying specific reference data group 61a is further displayed. Character information JB2 and character information JB3 for identifying normal reference data group 61b are further displayed. Character information JB1 is displayed larger than character information JB2 and character information JB3. Output section 72 can display character information JB1 in the same manner as the markers and the icons. The above description of the display method related to the substrate image can be similarly applied to the component accommodation image and the list display described below.

Output section 72 can also allow the display device 80 to display a component accommodation image of specific reference data group 61a schematically indicating the state in which multiple component accommodation sections are installed in component supply device 12 so as to be distinguishable from a component accommodation image of normal reference data group 61b schematically indicating the state in which multiple component accommodation sections are installed in component supply device 12.

Fig. 7 illustrates a display example of a component accommodation image when data group 60 is mounting-related data. In the drawing, the identification information for identifying specific reference data group 61a illustrated in Fig. 5 is illustrated by a component accommodation image when substrate product 900 is produced using the mounting-related data of specific reference data group 61a. In addition, the identification information for identifying normal reference data group 61b illustrated in Fig. 5 is illustrated by a component accommodation image when substrate product 900 is produced using the mounting-related data of normal reference data group 61b.

The component accommodation image in Fig. 7 is illustrated by the arrangement of five types of feeders 121 (denoted by feeders F1 to F5 for convenience of explanation) having different types of components 91 to be accommodated. In addition, the component accommodation image of specific reference data group 61a is indicated by solid lines, and the component accommodation image of normal reference data group 61b is indicated by dashed lines. As long as output section 72 can allow display device 80 to display multiple types of component accommodation images in a distinguishable manner, the display method is not limited.

The component accommodation image of specific reference data group 61a illustrated in the drawing indicates that feeder 121 is installed in component supply device 12 in the order of feeder F1, feeder F2, feeder F3, feeder F4, and feeder F5. The component accommodation image of one normal reference data group 61b indicates that feeder 121 is installed in component supply device 12 in the order of feeder F2, feeder F3, feeder F5, feeder F1, and feeder F4. The component accommodation image of another normal reference data group 61b indicates that feeder 121 is installed in component supply device 12 in the order of feeder F5, feeder F2, feeder F1, feeder F4, and feeder F3. It should be noted that component accommodation image displayed on display device 80 corresponds to an icon.

In the list display in which the identification information of multiple types of reference data groups 61 is listed, output section 72 can also allow display device 80 to display the identification information of specific reference data group 61a so as to be distinguishable from the identification information of normal reference data group 61b. As long as output section 72 can allow display device 80 to display the identification information of specific reference data group 61a so as to be distinguishable from the identification information of normal reference data group 61b, the display method is not limited.

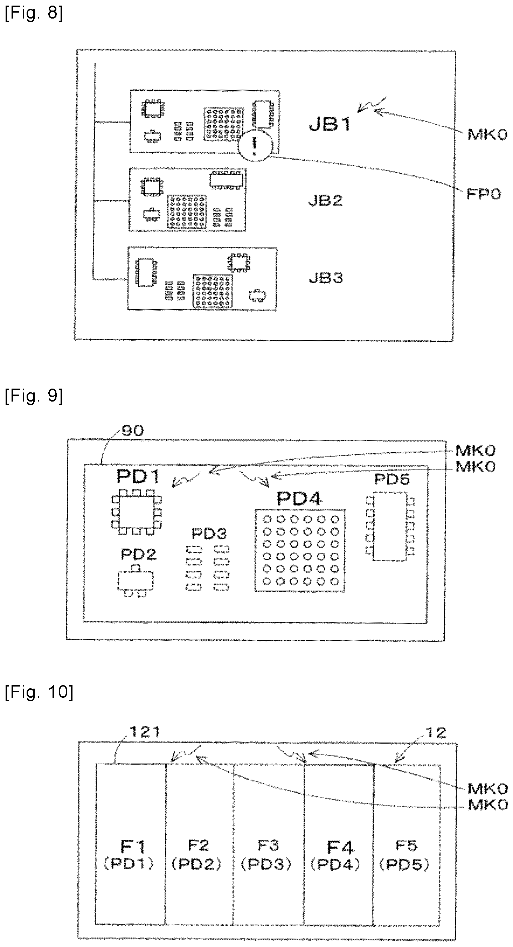

Fig. 8 illustrates a display example of a list display when data group 60 is mounting-related data. In the drawing, the identification information for identifying specific reference data group 61a illustrated in Fig. 5 and the identification information for identifying normal reference data group 61b are indicated by the substrate images (icons) described above, and the substrate images are displayed in a list. In Fig. 8, both the substrate images of specific reference data group 61a and normal reference data group 61b are indicated by solid lines. In addition, figure FP0 is appended to the substrate image of specific reference data group 61a. Figure FP0 corresponds to the marker described above. As figure FP0 in the drawing, an exclamation point for visually prompting attention is used.

### 1-3-3. Output example when data group 60 is component-related data

Next, it is assumed that data group 60 is component-related data. The component-related data includes data 50 in which component-related information, which is information about at least one of shape-related information including at least information about the shape of component 91, package information about the supply method of component 91, and inspection reference information used when inspecting the mounting state of component 91, is stored.

The information about the shape of component 91 includes information about the size of component 91. In a case where component 91 is a lead component, the information about the shape of component 91 includes information about the number, position (coordinates), orientation, length dimension, width dimension, pitch, and the like of the leads. Further, in a case where component 91 is a Ball GridArray (BGA) component, the information about the shape of component 91 includes information about the number, position (coordinates), diameter, pitch, and the like of bumps. In a case where a direction check mark is provided on component 91, information about shape of the component 91 includes information about the position, brightness, and the like of a direction check mark.

It should be noted that the shape-related information may include information about image processing of image data obtained by imaging the image of component 91. For example, the information on the image processing includes information about an algorithm for performing the image processing on the image data of component 91 imaged by part camera 14 or the like. In addition, the shape-related information may include information (handling information) about handling of component 91. For example, the handling information includes information (for example, nozzle diameter of suction nozzle) about holding member 30 used when holding component 91. In addition, the shape-related information may include information about an imaging condition when imaging the component 91, information about electrical characteristics of component 91, and the like.

For example, the package information includes information about the supply method of component 91 such as reel supply, tray supply, and stick supply. In addition, component mounter WM3 can image component 91 mounted on substrate 90 to acquire image data, perform image processing on the acquired image data, and recognize the mounting state of component 91. Component mounter WM3 inspects whether the mounting position, the rotation angle, and the like of recognized component 91 fall within an allowable range. The inspection reference information includes information about an inspection threshold value (allowable mounting range, allowable rotation angle, or the like) at the time of performing the above-described inspection.

In a substrate image schematically illustrating a state in which multiple components 91 are mounted on substrate 90, output section 72 can allow display device 80 to display component 91 of specific reference data group 61a so as to be distinguishable from component 91 of normal reference data group 61b.

Fig. 9 illustrates a display example of a substrate image when data group 60 is component-related data. In the drawing, the identification information for identifying specific reference data group 61a is indicated by a target component of specific reference data group 61a. In addition, the identification information for identifying normal reference data group 61b is indicated by a target component of normal reference data group 61b. In the drawing, the target component of specific reference data group 61a is indicated by solid lines, and the target component of normal reference data group 61b is indicated by dashed lines.

As illustrated in Fig. 9, in the description of the case where data group 60 is component-related data, five types of data groups 60 (two types of specific reference data groups 61a and three types of normal reference data groups 61b) are assumed for convenience of explanation. As long as output section 72 can allow display device 80 to display target components of multiple types of component-related data in a distinguishable manner, the display method is not limited. As in the case where data group 60 is the mounting-related data, output section 72 can change the display method of display device 80 according to at least one of a difference in display color, presence or absence of a marker, and a difference in an icon.

For example, output section 72 can display the target component of the specific reference data group 61a by a display color (for example, yellow, red, or the like) that is easier for the operator to pay attention to than the display color of the target component of normal reference data group 61b. Moreover, the same applies to the marker and the icon, and may take various forms such as a display color, a form, a movement in a display screen, and a blinking display that can be easily noticed by the operator. In Fig. 9, arrow MK0 is displayed for a target component of specific reference data group 61a. The target component of the component-related data displayed on display device 80 corresponds to an icon.

In Fig. 9, character information PD1 and character information PD4 for identifying specific reference data group 61a are further displayed. Character information PD2, character information PD3, and character information PD5 for identifying normal reference data group 61b are further displayed. Character information PD1 and character information PD4 are displayed larger than character information PD2, character information PD3, and character information PD5. Output section 72 can display character information PD1 and character information PD4 in the same manner as the markers and the icons. The above description of the display method related to the substrate image can be similarly applied to the component accommodation image and the list display described below.

In a component accommodation image schematically illustrating the state in which multiple component accommodation sections are installed in component supply device 12, output section 72 can also allow display device 80 to display a component accommodation section for accommodating component 91 of specific reference data group 61a so as to be distinguishable from a component accommodation section for accommodating component 91 of normal reference data group 61b.

Fig. 10 illustrates a display example of a component accommodation image when the data group 60 is component-related data. In the drawing, the identification information for identifying specific reference data group 61a is indicated by the component accommodation section for accommodating the target component of specific reference data group 61a. In addition, the identification information for identifying normal reference data group 61b is indicated by the component accommodation section for accommodating the target component of normal reference data group 61b.

The component accommodation image in Fig. 10 is illustrated by the arrangement of five types of feeders 121 (denoted by feeders F1 to F5 for convenience of explanation) that are different in the types of target components to be accommodated. In addition, the component accommodation sections (feeder F1 and feeder F4) for accommodating the target component of specific reference data group 61a are indicated by solid lines, and the component accommodation sections (feeder F2, feeder F3, and feeder F5) for accommodating the target component of normal reference data group 61b are indicated by dashed lines. As long as output section 72 may allow display device 80 to display a component accommodation section for accommodating a target component of multiple types of component-related data so as to be distinguishable, the display method is not limited. It should be noted that the component accommodation section for accommodating the target component of the component-related data displayed on display device 80 corresponds to an icon.

Even in a case where data group 60 is the component-related data, output section 72 can allow display device 80 to display the identification information of specific reference data group 61a so as to be distinguishable from the identification information of normal reference data group 61b in the list display in which the identification information of multiple types of reference data groups 61 is listed. As long as output section 72 can allow display device 80 to display the identification information of specific reference data group 61a so as to be distinguishable from the identification information of normal reference data group 61b, the display method is not limited.

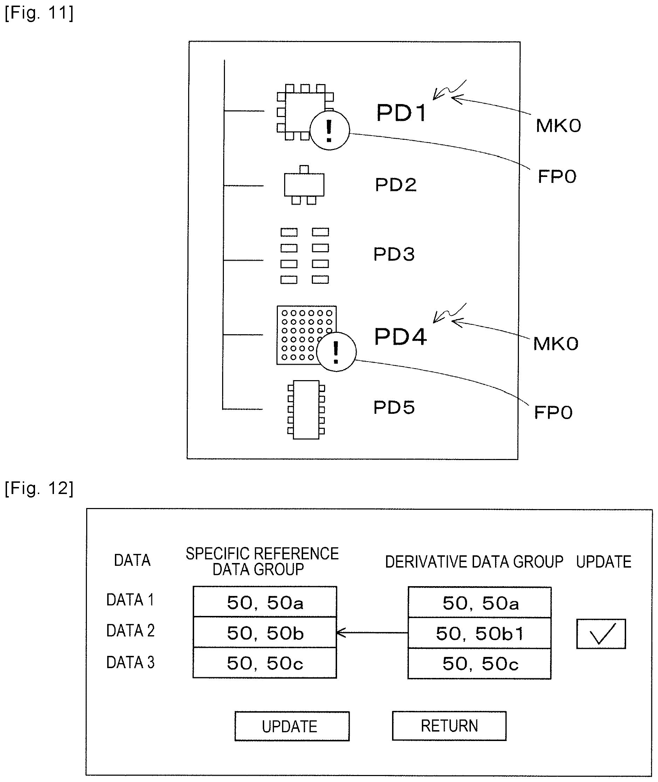

Fig. 11 illustrates a display example of a list display when data group 60 is the component-related data. In the drawing, the identification information for identifying specific reference data group 61a and the identification information for identifying normal reference data group 61b are indicated by the target components (icons) of the component-related data described above, and the target components of the component-related data are displayed in a list. In Fig. 11, the target components of specific reference data group 61a and normal reference data group 61b are both indicated by solid lines. In addition, figure FP0 is appended to the target component of specific reference data group 61a. Figure FP0 corresponds to the marker described above. As figure FP0 in the drawing, an exclamation point for visually prompting attention is used.

### 1-3-4. Other output examples

The mounting-related data may also include component-related data. In this case, when the component-related data is difference data 51, output section 72 can also allow display device 80 to display component 91 (target component of the component-related data) of difference data 51 so as to be distinguishable, in a substrate image schematically illustrating a state in which multiple components 91 are mounted on substrate 90. Specifically, output section 72 allows display device 80 to display component 91 (target component) of difference data 51 of specific reference data group 61a so as to be distinguishable from component 91 (target component) of difference data 51 of normal reference data group 61b.

In addition, when the component-related data is difference data 51, output section 72 can also allow display device 80 to display the component accommodation section for accommodating component 91 (target component of component-related data) of difference data 51 so as to be distinguishable, in the component accommodation image schematically illustrating the state in which multiple component accommodation sections are installed in component supply device 12. Specifically, output section 72 allows display device 80 to display the component accommodation section for accommodating component 91 (target component) of difference data 51 of specific reference data group 61a so as to be distinguishable from the component accommodation section for accommodating component 91 (target component) of difference data 51 of normal reference data group 61b.

For example, the difference between data 50 in which information about the shape of component 91 such as the size of component 91 is stored is included in the difference between data 50 caused by the individual difference between components 91. For example, the individual difference between components 91 is caused by a difference in a manufacturing lot of component 91, a difference in a manufacturing maker of component 91, or the like. The difference in data 50 caused by the individual difference between components 91 occurs, for example, as a result of data 50 being changed in accordance with component 91 to be supplied in a trial production, initial product confirmation, a main production, a repeat production, simulation, or the like of substrate product 900. Changed data 50 is used in the production of substrate product 900 on which component 91 is mounted.

The difference in data 50 in which the information about the devices such as substrate working line WL0 and component mounter WM3 is stored is included in the difference in data 50 caused by the individual difference between the devices used in the mounting process. The difference in data 50 caused by the individual difference between the devices occurs, for example, as a result of data 50 being changed in accordance with the production facility in the trial production, the initial product confirmation, the main production, the repeat production, the simulation, or the like of substrate product 900. Changed data 50 is used in the production of substrate product 900 using the production facility. It is not preferable to change data 50 (in particular, master data) of another data group 60 using data 50 optimized for specific component 91 or a specific production facility.

Therefore, in any of the above-described forms, output section 72 can change the display method of display device 80 in accordance with the difference in data 50 caused by the individual difference of component 91 or the individual difference of the device used in the mounting process, and the difference in data 50 caused by factors other than the individual difference. As a result, the operator can easily distinguish the difference between data 50 caused by the individual difference and the difference between data 50 caused by a factor other than the individual difference. It should be noted that output section 72 can change the display method of display device 80, for example, according to at least one of the difference in display color, the presence or absence of a marker, and the difference in an icon.

### 1-3-5. Configuration example of updating section 73

For example, information about the image processing of the image data obtained by imaging component 91, information about the handling of component 91, information about the imaging condition when imaging component 91, information about the use condition of the device, and the like are information useful for improving the mounting process. Therefore, in order to improve the mounting process, it may be preferable to change data 50 (particularly the master data) of other data groups 60, using data 50 in which such information is stored.

Therefore, data management device 70 of the present embodiment includes updating section 73. Updating section 73 uses difference data 51 of derivative data group 63 to determine the enablement of update processing for updating at least one piece of data 50 that is corresponding to specific reference data group 61a with which derivative data group 63 is associated (Step S13 illustrated in Fig. 4).

As described above, display device 80 includes a touch panel, and also serves as an input device for receiving various operations by the operator. For example, on the display screen illustrated in Fig. 6, when the operator touches the substrate image of specific reference data group 61a or character information JB1 for identifying specific reference data group 61a, a screen illustrated in Fig. 12 is displayed.

Fig. 12 illustrates a display example of correspondence data between specific reference data group 61a and derivative data group 63. In the display example illustrated in the drawing, a type of data 50 included in specific reference data group 61a and derivative data group 63, a setting value of data 50, and a selection box through which difference data 51 to be updated can be selected are displayed. In the display example illustrated in the drawing, difference data 51 is data 50b1. In any of the display screens in Figs. 7 to 11, correspondence data between specific reference data group 61a and derivative data group 63 are displayed in the same manner.

In the present embodiment, the operator can select difference data 51 to be updated by selecting the selection box illustrated in the drawing. Updating section 73 allows the update processing of difference data 51 selected by the operator when difference data 51 is selected by the operator and the update button is selected. Updating section 73 disables the update processing when no difference data 51 is selected or when the operator selects a return button.

In addition, updating section 73 can also allow the update processing of difference data 51 selected by the operator when approval of an administrator who determines appropriateness of the update processing is received. Conversely, updating section 73 may disable the update processing of difference data 51 selected by the operator when the approval of the administrator is not received. In this case, updating section 73 can display a message that the approval of the administrator is not received and the update processing is not performed.

In addition, as described above, it is not preferable to change data 50 (particularly, the master data) of another data group 60 using data 50 optimized for specific component 91 or a specific production facility. Therefore, updating section 73 can also prohibit the update of data 50 for the difference of data 50 caused by the individual difference of component 91 or the individual difference of the device used in the mounting process.

For example, it is assumed that a difference between data 50b included in specific reference data group 61a illustrated in Fig. 12 and data 50b1 included in derivative data group 63 is caused by the individual difference of component mounter WM3. In this case, updating section 73 disables the update processing for updating data 50b of specific reference data group 61a using data 50b1 of derivative data group 63. Specifically, updating section 73 displays a non-selectable display so that the operator cannot select the selection box of data 50b1. In this case, updating section 73 can display a message that the difference between data 50b and data 50b1 is caused by the individual difference of component mounter WM3.

### 2. Data management method

The above description of data management device 70 also applies to a data management method. Specifically, the data management method includes a determination step and an output step. The determination step corresponds to control performed by the determination section 71. The output step corresponds to control performed by the output section 72. In addition, the data management method may include an updating step. The updating step corresponds to control performed by the updating section 73.

### 3. Example of effects of embodiment

According to data management device 70, determination section 71 and output section 72 are provided. As a result, data management device 70 can identify specific reference data group 61a with which derivative data group 63 in which at least one data 50 included in data group 60 is changed is associated. The above description of data management device 70 also applies to the data management method.

### Reference Signs List

12: component supply device, 50: data, 51: difference data, 60: data group, 61: reference data group, 61a: specific reference data group, 61b: normal reference data group, 62: association data group, 63: derivative data group, 70: data management device, 71: determination section, 72: output section, 73: updating section, 80: display device, 90: substrate, 91: component

## Claims

1. A data management device (70) used in a mounting line (WL) configured for mounting a component (91) on a substrate (90), the device (70) comprising:
when a set of data (50) used in a mounting process of mounting the component (91) on the substrate (90) is defined as a data group (60), one of multiple data groups (60) is defined as a reference data group (61), the data group (60) managed in association with the reference data group (61) is defined as an association data group (62), and one of the association data groups (62) that includes difference data (51), which is data corresponding to the data (50) of the reference data group (61) that differs from the data (50) of the reference data group (61), is defined as a derivative data group (63),
**characterized by**
a determination section (71) configured to determine whether any of the association data groups (62) associated with each of multiple types of the reference data groups (61) is a derivative data group (63); and
an output section (72) configured to output identification information identifying a specific reference data group (61a), which is a reference data group (61) with which a derivative data group (63) is associated, so as to be distinguishable from identification information identifying a normal reference data group (61b), which is a reference data group (61) with which no derivative data group (63) is associated, based on a determination result by the determination section (71).

2. The data management device (70) according to claim 1,
wherein the data group (60) is mounting-related data including the data (50) in which mounting-related information that is information about at least one of a pickup position of the component (91) to be used in the mounting process, a mounting position of the component (91), a mounting order of the component (91), a device (WM3) to be used in the mounting process, and a use condition of the device (WM3) is stored.

3. The data management device (70) according to claim 2,
wherein the output section (72) is configured to allow a display device (80) to display a substrate image of the specific reference data group (61a) schematically indicating a state in which multiple components (91) are mounted on the substrate (90) so as to be distinguishable from a substrate image of the normal reference data group (61b) schematically indicating a state in which the multiple components (91) are mounted on the substrate (90).

4. The data management device (70) according to claim 2,
wherein the output section (72) is configured to allow a display device (80) to display a component accommodation image of the specific reference data group (61a) schematically indicating a state in which multiple component accommodation sections are installed in a component supply device (12) so as to be distinguishable from a component accommodation image of the normal reference data group (61b) schematically indicating a state in which the multiple component accommodation sections are installed in the component supply device (12).

5. The data management device (70) according to claim 1,
wherein the data group (60) is component-related data including the data (50) in which component-related information that is information about at least one of shape-related information including at least information about a shape of the component (91), package information about a supply method of the component (91), and inspection reference information used when inspecting a mounting state of the component (91) is stored.

6. The data management device (70) according to claim 5,
wherein the output section (72) is configured to allow a display device (80) to display the component (91) of the specific reference data group (61a) so as to be distinguishable from the component (91) of the normal reference data group (61b), in a substrate image schematically illustrating a state in which multiple components (91) are mounted on the substrate (90).

7. The data management device (70) according to claim 5,
wherein the output section (72) is configured to allow a display device (80) to display a component accommodation section for accommodating the component (91) of the specific reference data group (61a) so as to be distinguishable from a component accommodation section for accommodating the component (91) of the normal reference data group (61b), in a component accommodation image schematically illustrating a state in which multiple component accommodation sections are installed in a component supply device (12).

8. The data management device (70) according to any one of claims 1, 2, and 5,
wherein the output section (72) is configured to allow a display device (80) to display identification information of the specific reference data group (61a) so as to be distinguishable from identification information of the normal reference data group (61b), in a list display in which identification information of multiple types of the reference data groups (61) is listed.

9. The data management device (70) according to any one of claims 3, 4, and 6 to 8,
wherein the output section (72) is configured to change a display method of the display device (80) according to at least one of a difference in display color, presence or absence of a marker, and a difference in an icon.

10. The data management device (70) according to any one of claims 3, 4, and 6 to 9,
wherein the output section (72) configured to change a display method of the display device (80) in accordance with a difference in the data (50) caused by an individual difference of the component (91) or an individual difference of a device (WM3) used in the mounting process, and a difference in the data (50) caused by a factor other than the individual difference.

11. The data management device (70) according to any one of claims 1 to 10, further comprising an updating section (73) configured to determine an enablement of update processing for updating at least one piece of data (50) that corresponds to the specific reference data group (61a) with which the derivative data group (63) is associated, the enablement being determined by using the difference data (51) of the derivative data group (63).

12. The data management device (70) according to claim 11,
wherein the updating section (73) is configured to prohibit updating of the data (50) for a difference in the data (50) caused by an individual difference of the component (91) or an individual difference of a device (WM3) used in the mounting process.

13. A data management method used in a mounting line (WL) configured for mounting a component (91) on a substrate (90), the method comprising:
when a set of data (50) used in a mounting process of mounting the component (91) on the substrate (90) is defined as a data group (60), one of multiple data groups (60) is defined as a reference data group (61), the data group (60) managed in association with the reference data group (61) is defined as an association data group (62), and one of the association data groups (62) that includes difference data (51), which is data corresponding to the data (50) of the reference data group (61) that differs from the data (50) of the reference data group (61), is defined as a derivative data group (63),
**characterized by**
a determination step of determining whether any of the association data groups (62) associated with each of multiple types of the reference data groups (61) is a derivative data group (63); and
an output step of outputting identification information identifying a specific reference data (50) group, which is a reference data (50) group with which a derivative data (50) group is associated, so as to be distinguishable from identification information identifying a normal reference data (50) group, which is a reference data (50) group with which no derivative data (50) group is associated, based on a determination result in the determination step.

## Patentansprüche

1. Datenverwaltungsvorrichtung (70) die in einer Montagelinie (WL) verwendet wird, die zum Montieren einer Komponente (91) auf einem Substrat (90) konfiguriert ist, wobei die Vorrichtung (70) Folgendes umfasst:
wenn ein Datensatz (50), der in einem Montageprozess zum Montieren der Komponente (91) auf dem Substrat (90) verwendet wird, als eine Datengruppe (60) definiert ist, wird eine von mehreren Datengruppen (60) als Referenzdatengruppe (61) definiert, wird die in Verbindung mit der Referenzdatengruppe (61) verwaltete Datengruppe (60) als Assoziationsdatengruppe (62) definiert, und wird eine der Assoziationsdatengruppen (62), die Differenzdaten (51) enthält, bei denen es sich um Daten handelt, die den Daten (50) der Referenzdatengruppe (61) entsprechen und sich von den Daten (50) der Referenzdatengruppe (61) unterscheiden, als Derivatdatengruppe (63) definiert,
**gekennzeichnet durch**
einen Bestimmungsabschnitt (71), der konfiguriert ist, um zu bestimmen, ob irgendeine der Assoziationsdatengruppen (62), die mit jedem von mehreren Typen der Referenzdatengruppen (61) verbunden sind, eine Derivatdatengruppe (63) ist; und
einen Ausgabeabschnitt (72), der dazu konfiguriert ist, auf der Grundlage eines Bestimmungsergebnisses durch den Bestimmungsabschnitt (71) Identifikationsinformationen auszugeben, die eine bestimmte Referenzdatengruppe (61a) identifizieren, bei der es sich um eine Referenzdatengruppe (61) handelt, der eine abgeleitete Datengruppe (63) zugeordnet ist, so dass sie von Identifikationsinformationen unterscheidbar sind, die eine normale Referenzdatengruppe (61b) identifizieren, bei der es sich um eine Referenzdatengruppe (61) handelt, der keine abgeleitete Datengruppe (63) zugeordnet ist.

2. Datenverwaltungsvorrichtung (70) gemäß Anspruch 1,
wobei es sich bei der Datengruppe (60) um montagebezogene Daten handelt, die die Daten (50) umfassen, in denen montagebezogene Informationen gespeichert sind, das heißt Informationen über mindestens eine der folgenden Informationen: eine Aufnahmeposition der im Montageprozess zu verwendenden Komponente (91), eine Montageposition der Komponente (91), eine Montagereihenfolge der Komponente (91), eine im Montageprozess zu verwendende Vorrichtung (WM3) und einen Verwendungszustand der Vorrichtung (WM3).

3. Datenverwaltungsvorrichtung (70) nach Anspruch 2,
wobei der Ausgabeabschnitt (72) so konfiguriert ist, dass er es einer Anzeigevorrichtung (80) ermöglicht, ein Substratbild der spezifischen Referenzdatengruppe (61a) anzuzeigen, das schematisch einen Zustand anzeigt, in dem mehrere Komponenten (91) auf dem Substrat (90) montiert sind, so dass es von einem Substratbild der normalen Referenzdatengruppe (61b) unterscheidbar ist, das schematisch einen Zustand anzeigt, in dem die mehreren Komponenten (91) auf dem Substrat (90) montiert sind.

4. Datenverwaltungsvorrichtung (70) nach Anspruch 2,
wobei der Ausgabeabschnitt (72) so konfiguriert ist, dass er es einer Anzeigevorrichtung (80) ermöglicht, ein Komponentenaufnahmebild der spezifischen Referenzdatengruppe (61a) anzuzeigen, das schematisch einen Zustand angibt, in dem mehrere Komponentenaufnahmeabschnitte in einer Komponentenversorgungsvorrichtung (12) installiert sind, so dass es von einem Komponentenaufnahmebild der normalen Referenzdatengruppe (61b) unterscheidbar ist, das schematisch einen Zustand angibt, in dem die mehreren Komponentenaufnahmeabschnitte in der Komponentenversorgungsvorrichtung (12) installiert sind.

5. Datenverwaltungsvorrichtung (70) nach Anspruch 1,
wobei es sich bei der Datengruppe (60) um komponentenbezogene Daten handelt, die die Daten (50) umfassen, in denen komponentenbezogene Informationen gespeichert sind, das heißt Informationen über mindestens eine Art von formbezogenen Informationen, die mindestens Informationen über eine Form der Komponente (91), Verpackungsinformationen über ein Lieferverfahren der Komponente (91) und Inspektionsreferenzinformationen, die bei der Inspektion eines Montagezustands der Komponente (91) verwendet werden, umfassen.

6. Datenverwaltungsvorrichtung (70) nach Anspruch 5,
wobei der Ausgabeabschnitt (72) so konfiguriert ist, dass er es einer Anzeigevorrichtung (80) ermöglicht, die Komponente (91) der spezifischen Referenzdatengruppe (61a) so anzuzeigen, dass sie von der Komponente (91) der normalen Referenzdatengruppe (61b) unterscheidbar ist, und zwar in einem Substratbild, das schematisch einen Zustand darstellt, in dem mehrere Komponenten (91) auf dem Substrat (90) montiert sind.

7. Datenverwaltungsvorrichtung (70) nach Anspruch 5,
wobei der Ausgabeabschnitt (72) so konfiguriert ist, dass er es einer Anzeigevorrichtung (80) ermöglicht, einen Komponentenaufnahmeabschnitt zur Aufnahme der Komponente (91) der spezifischen Referenzdatengruppe (61a) so anzuzeigen, dass er von einem Komponentenaufnahmeabschnitt zur Aufnahme der Komponente (91) der normalen Referenzdatengruppe (61b), unterscheidbar ist, und zwar in einem Komponentenaufnahmebild, das schematisch einen Zustand darstellt, in dem mehrere Komponentenaufnahmeabschnitte in einer Komponentenzufuhrvorrichtung (12) installiert sind.

8. Datenverwaltungsvorrichtung (70) nach einem der Ansprüche 1, 2 und 5,
wobei der Ausgabeabschnitt (72) so konfiguriert ist, dass er es einer Anzeigevorrichtung (80) ermöglicht, Identifikationsinformationen der spezifischen Referenzdatengruppe (61a) so anzuzeigen, dass sie von Identifikationsinformationen der normalen Referenzdatengruppe (61b) unterscheidbar sind, und zwar in einer Listenanzeige, in der Identifikationsinformationen mehrerer Typen der Referenzdatengruppen (61) aufgelistet werden.

9. Die Datenverwaltungsvorrichtung (70) nach einem der Ansprüche 3, 4 und 6 bis 8,
wobei der Ausgabeabschnitt (72) so konfiguriert ist, dass er ein Anzeigeverfahren der Anzeigevorrichtung (80) in Übereinstimmung mit mindestens einem der folgenden Faktoren ändert: Unterschied in der Anzeigefarbe, dem Vorhandensein oder Fehlen einer Markierung und einem Unterschied in einem Symbol.

10. Die Datenverwaltungsvorrichtung (70) nach einem der Ansprüche 3, 4 und 6 bis 9,
wobei der Ausgabeabschnitt (72) so konfiguriert ist, dass er ein Anzeigeverfahren der Anzeigevorrichtung (80) in Übereinstimmung mit einem Unterschied in den Daten (50), der durch einen individuellen Unterschied der Komponente (91) oder einen individuellen Unterschied einer im Montageprozess verwendeten Vorrichtung (WM3) verursacht wird, und einem Unterschied in den Daten (50), der durch einen anderen Faktor als den individuellen Unterschied verursacht wird, ändert.

11. Datenverwaltungsvorrichtung (70) nach einem der Ansprüche 1 bis 10, die ferner einen Aktualisierungsabschnitt (73) umfasst, der so konfiguriert ist, dass er eine Aktivierung der Aktualisierungsverarbeitung zum Aktualisieren von mindestens einem Datenelements (50) bestimmt, das der spezifischen Referenzdatengruppe (61a) entspricht, der die Derivatdatengruppe (63) zugeordnet ist, wobei die Aktivierung unter Verwendung der Differenzdaten (51) der abgeleiteten Datengruppe (63) bestimmt wird.

12. Datenverwaltungsvorrichtung (70) nach Anspruch 11,
wobei der Aktualisierungsabschnitt (73) so konfiguriert ist, dass er die Aktualisierung der Daten (50) bei einem Unterschied in den Daten (50), der durch einen individuellen Unterschied der Komponente (91) oder einen individuellen Unterschied einer im Montageprozess verwendeten Vorrichtung (WM3) verursacht wird, verhindert.

13. Datenverwaltungsverfahren, das in einer Montagelinie (WL) verwendet wird, die zum Montieren einer Komponente (91) auf einem Substrat (90) konfiguriert ist, wobei das Verfahren Folgendes umfasst:
wenn ein Datensatz (50), der in einem Montageprozess zum Montieren der Komponente (91) auf dem Substrat (90) verwendet wird, als eine Datengruppe (60) definiert ist, wird eine von mehreren Datengruppen (60) als Referenzdatengruppe (61) definiert, wird die in Verbindung mit der Referenzdatengruppe (61) verwaltete Datengruppe (60) als Assoziationsdatengruppe (62) definiert, und wird eine der Assoziationsdatengruppen (62), die Differenzdaten (51) enthält, bei denen es sich um Daten handelt, die den Daten (50) der Referenzdatengruppe (61) entsprechen und sich von den Daten (50) der Referenzdatengruppe (61) unterscheiden, als Derivatdatengruppe (63) definiert,
**gekennzeichnet durch**
einen Bestimmungsschritt zum Bestimmen, ob irgendeine der Assoziationsdatengruppen (62), die mit jedem von mehreren Typen der Referenzdatengruppen (61) verbunden sind, eine Derivatdatengruppe (63) ist; und
einen Ausgabeschritt zum Ausgeben von Identifikationsinformationen, die eine bestimmte Referenzdatengruppe (61a) identifizieren, bei der es sich um eine Referenzdatengruppe (61) handelt, der eine abgeleitete Datengruppe (63) zugeordnet ist, so dass sie von Identifikationsinformationen unterscheidbar sind, die eine normale Referenzdatengruppe (61b) identifizieren, bei der es sich um eine Referenzdatengruppe (61) handelt, der keine abgeleitete Datengruppe (63) zugeordnet ist, auf der Grundlage eines Bestimmungsergebnisses in dem Bestimmungsschritt.

## Revendications

1. Dispositif de gestion de données (70) utilisé dans une ligne de montage (WL) configurée pour monter un composant (91) sur un substrat (90), le dispositif (70) comprenant :
quand un jeu de données (50) utilisé dans un processus de montage du composant (91) sur le substrat (90) est défini comme un groupe de données (60), l'un des multiples groupes de données (60) est défini comme un groupe de données de référence (61), le groupe de données (60) géré en association avec le groupe de données de référence (61) est défini comme un groupe de données d'association (62), et l'un des groupes de données d'association (62) qui comprend des données de différence (51), qui sont des données correspondant aux données (50) du groupe de données de référence (61) qui diffèrent des données (50) du groupe de données de référence (61), est défini comme un groupe de données dérivées (63),
**caractérisé par**
une section de détermination (71) configurée pour déterminer si l'un quelconque des groupes de données d'association (62) associés à chacun des multiples types des groupes de données de référence (61) est ou non un groupe de données dérivées (63) ; et
une section de sortie (72) configurée pour sortir de l'information d'identification identifiant un groupe de données de référence spécifique (61a), qui est un groupe de données de référence (61) auquel un groupe de données dérivées (63) est associé, de manière à être distinguable de l'information d'identification identifiant un groupe de données de référence normal (61b), qui est un groupe de données de référence (61) auquel aucun groupe de données dérivées (63) n'est associé, sur la base d'un résultat de détermination par la section de détermination (71).

2. Dispositif de gestion de données (70) selon la revendication 1,
dans lequel le groupe de données (60) est constitué de données relatives au montage comprenant les données (50) dans lesquelles est stockée de l'information relative au montage, qui est au moins une information parmi une position de saisie du composant (91) à utiliser dans le processus de montage, une position de montage du composant (91), un ordre de montage du composant (91), un dispositif (WM3) à utiliser dans le processus de montage, et une condition d'utilisation du dispositif (WM3).

3. Dispositif de gestion de données (70) selon la revendication 2,
dans lequel la section de sortie (72) est configurée pour permettre à un dispositif d'affichage (80) d'afficher une image de substrat du groupe de données de référence spécifique (61a) indiquant schématiquement un état dans lequel de multiples composants (91) sont montés sur le substrat (90) de manière à être distinguable d'une image de substrat du groupe de données de référence normal (61b) indiquant schématiquement un état dans lequel les multiples composants (91) sont montés sur le substrat (90).

4. Dispositif de gestion de données (70) selon la revendication 2,
dans lequel la section de sortie (72) est configurée pour permettre à un dispositif d'affichage (80) d'afficher une image de logement de composant du groupe de données de référence spécifique (61a) indiquant schématiquement un état dans lequel de multiples sections de logement de composant sont installées dans un dispositif d'approvisionnement en composants (12) de manière à être distinguable d'une image de logement de composant du groupe de données de référence normal (61b) indiquant schématiquement un état dans lequel les multiples sections de logement de composant sont installées dans le dispositif d'approvisionnement en composants (12).

5. Dispositif de gestion de données (70) selon la revendication 1,
dans lequel le groupe de données (60) est constitué de données relatives au composant comprenant les données (50) dans lesquelles est stockée de l'information relative au composant qui est au moins une information parmi de l'information de forme comprenant au moins de l'information concernant une forme du composant (91), de l'information de paquet concernant un procédé d'approvisionnement du composant (91), et de l'information de référence d'inspection utilisée lors de l'inspection d'un état de montage du composant (91).

6. Dispositif de gestion de données (70) selon la revendication 5,
dans lequel la section de sortie (72) est configurée pour permettre à un dispositif d'affichage (80) d'afficher le composant (91) du groupe de données de référence spécifique (61a) de manière à être distinguable du composant (91) du groupe de données de référence normal (61b), dans une image de substrat illustrant schématiquement un état dans lequel de multiples composants (91) sont montés sur le substrat (90) .

7. Dispositif de gestion de données (70) selon la revendication 5,
dans lequel la section de sortie (72) est configurée pour permettre à un dispositif d'affichage (80) d'afficher une section de logement de composant pour loger le composant (91) du groupe de données de référence spécifique (61a) de manière à être distinguable d'une section de logement de composant pour loger le composant (91) du groupe de données de référence normal (61b), dans une image de logement de composant illustrant schématiquement un état dans lequel de multiples sections de logement de composant sont installées dans un dispositif d'approvisionnement en composants (12).

8. Dispositif de gestion de données (70) selon l'une quelconque des revendications 1, 2 et 5,
dans lequel la section de sortie (72) est configurée pour permettre à un dispositif d'affichage (80) d'afficher de l'information d'identification du groupe de données de référence spécifique (61a) de manière à être distinguable de l'information d'identification du groupe de données de référence normal (61b), dans un affichage de répertoire dans lequel des informations d'identification de multiples types de groupes de données de référence (61) sont répertoriées.

9. Dispositif de gestion de données (70) selon l'une quelconque des revendications 3, 4 et 6 à 8,
dans lequel la section de sortie (72) est configurée pour changer un procédé d'affichage du dispositif d'affichage (80) en fonction d'au moins paramètre parmi une différence de couleur d'affichage, la présence ou l'absence d'un marqueur, et une différence dans une icône.

10. Dispositif de gestion de données (70) selon l'une quelconque des revendications 3, 4 et 6 à 9,
dans lequel la section de sortie (72) est configurée pour changer un procédé d'affichage du dispositif d'affichage (80) conformément à une différence dans les données (50) provoquée par une différence individuelle du composant (91) ou une différence individuelle d'un dispositif (WM3) utilisé dans le processus de montage, et d'une différence dans les données (50) provoquée par un facteur autre que la différence individuelle.

11. Dispositif de gestion de données (70) selon l'une quelconque des revendications 1 à 10, comprenant en outre une section de mise à jour (73) configurée pour déterminer une activation du traitement de mise à jour pour mettre à jour au moins un élément de donnée (50) qui correspond au groupe de données de référence spécifique (61a) auquel le groupe de données dérivées (63) est associé, l'activation étant déterminée en utilisant les données de différence (51) du groupe de données dérivées (63).

12. Dispositif de gestion de données (70) selon la revendication 11,
dans lequel la section de mise à jour (73) est configurée pour interdire la mise à jour des données (50) pour une différence dans les données (50) provoquée par une différence individuelle du composant (91) ou par une différence individuelle d'un dispositif (WM3) utilisé dans le processus de montage.

13. Procédé de gestion de données utilisé dans une ligne de montage (WL) configurée pour monter un composant (91) sur un substrat (90), dans lequel :
quand un jeu de données (50) utilisé dans un processus de montage du composant (91) sur le substrat (90) est défini comme un groupe de données (60), l'un des multiples groupes de données (60) est défini comme un groupe de données de référence (61), le groupe de données (60) géré en association avec le groupe de données de référence (61) est défini comme un groupe de données d'association (62), et l'un des groupes de données d'association (62) qui comprend des données de différence (51), qui sont des données correspondant aux données (50) du groupe de données de référence (61) qui diffèrent des données (50) du groupe de données de référence (61), est défini comme un groupe de données dérivées (63),
**caractérisé par**
une étape de détermination consistant à déterminer si l'un quelconque des groupes de données d'association (62) associés à chacun des multiples types des groupes de données de référence (61) est ou non un groupe de données dérivées (63) ; et
une étape de sortie consistant à sortir de l'information d'identification identifiant un groupe de données de référence (50) spécifique, qui est un groupe de données de référence (50) auquel un groupe de données dérivées (50) est associé, de manière à être distinguable de l'information d'identification identifiant un groupe de données de référence (50) normal, qui est un groupe de données de référence (50) auquel aucun groupe de données dérivées (50) n'est associé, sur la base d'un résultat de détermination à l'étape de détermination.
